# EUROPEAN PATENT APPLICATION

(11) **EP 4 764 767 A1**
(43) Date of publication of application: **24.06.2026**
(21) Application number: 24222390.7
(22) Date of filing: 20.12.2024
(51) Int. Cl.: G06F 1/10, H01L 25/065, H10D 88/00

(54) **A 3D INTEGRATED CIRCUIT DEVICE**

(71) Applicant: Imec VZW, 3001 Leuven (BE)
(72) Inventor: DUBEY, Prashant, CB23 7EU Cambridgeshire (BE); ZOGRAFOS, Odysseas, 3010 Kessel-Lo (BE); GUERRA GOMEZ, Ivick, 3001 Leuven (BE); VENUGOPAL, Priya, 3210 Linden, Lubbeek (BE)
(74) Representative: Lind Edlund Kenamets Intellectual Property AB

(57) **Abstract**

According to an aspect, there is provided a 3D IC device comprising:
a first semiconductor device tier comprising a first set of active devices;
a second semiconductor device tier comprising a second set of active devices;
a clocked circuit comprising first active devices comprised in the first set of active devices of the first semiconductor device tier; and
a clock distribution network comprising a plurality of clock signal routing interconnects arranged in an interconnect structure arranged at a side of the first semiconductor device tier facing the second semiconductor device tier, and a set of active clock devices formed by second active devices comprised in the second set of active devices of the second semiconductor device tier;
wherein the clocked circuit is connected to the clock distribution network to receive a clock signal

## Description

### TECHNICAL FIELD

The present invention generally relates to a 3D integrated circuit device.

### BACKGROUND

Clock distribution is an important consideration in design of integrated circuit (IC) devices including synchronous circuits.

A common implementation of a clock distribution network is a clock tree, such as an H-tree. The cumulative wire length of a clock tree of a typical state-of-the-art IC may be relatively long, for instance spanning more than 200 mm for a 1 mm² portion of a die, where a greater number of sink nodes along the clock distribution network tends to be associated with increased wire lengths.

A conventional approach for clock distribution is to route the clock signal at the frontside of the die of the IC device, i.e., using the back-end-of-line (BEOL) interconnect structure on the frontside of the die ("frontside interconnect structure"). More recently, IC designs where the clock signal instead are routed using a BEOL interconnect structure on the backside of the die ("backside interconnect structure") have been proposed.

A benefit of backside routing of the clock signal is that competition for routing resources in the frontside interconnect structure (which also are needed for routing non-clock signals) may be reduced.

### SUMMARY

While there are benefits to backside routing of the clock signal, it may also introduce additional challenges in the circuit design. For instance, there is an area penalty associated with connecting the clock signal between the backside and the active devices on the frontside, which increases in proportion to the number of times the signal is routed between the backside and the frontside. Moreover, given the trend in the industry to incorporate the power delivery network (PDN) in the backside interconnect structure (a backside PDN), the backside interconnect structure may typically comprise metal layers with relatively wide and closely spaced metal lines for power rails. This may limit the available space on the backside for contacts for routing the clock signal to the frontside. Therefore, a large number of connections between the clock signal and the backside and the frontside may necessitate less dense metal layers for power routing and/or breaking the continuity of the power rails, which both may be degrade the performance of the PDN.

In view of the above, it is an object to provide improved approaches for designing IC devices to allow backside routing of the clock signal with less area penalty. Further, it is an object to provide improved approaches for designing IC devices to allow backside routing of the clock signal while requiring smaller number of connections of the clock signal between the backside and frontside. Further and alternative objects may be appreciated from the following.

According to an aspect of the present invention, there is provided a 3D IC device comprising:
a first semiconductor device tier comprising a first set of active devices;
a second semiconductor device tier comprising a second set of active devices;
a clocked circuit comprising first active devices comprised in the first set of active devices of the first semiconductor device tier; and
a clock distribution network comprising a plurality of clock signal routing interconnects arranged in an interconnect structure arranged at a side of the first semiconductor device tier facing the second semiconductor device tier, and a set of active clock devices formed by second active devices comprised in the second set of active devices of the second semiconductor device tier;
wherein the clocked circuit is connected to the clock distribution network to receive a clock signal.

The 3D IC device is based, at least in part, on the insight that by arranging the active devices (i.e., transistors) of active clock devices of the clock distribution network in a second semiconductor device tier, a more area efficient implementation of the connections between the clock distribution network and the clocked circuit, and thus a more area efficient clocked circuit and IC device, may be realized. In particular, arranging the active devices (second active devices) of the active clock devices in the second semiconductor device tier allows reducing a number of connections between the clock distribution network and the first semiconductor device tier, compared to had the transistors of the active clock devices, as is conventionally done, been arranged in the first semiconductor device tier. Hence, fewer contacts are needed for routing the clock signal from the side of the first semiconductor device tier facing the second semiconductor device tier ("second side of the first semiconductor device tier") through the first semiconductor device tier, to the opposite side of the first semiconductor device tier ("first side of the first semiconductor device tier").

Moreover, by arranging the second active devices of the active clocked devices in the second semiconductor device tier, the footprint occupied in the first semiconductor device tier by active devices of the clock distribution network may be reduced. This may also simplify the design process, by allowing a more flexible placement of the active clock devices in the second semiconductor device tier.

That is, the active clock devices may be provided at the locations within the second semiconductor device tier where they confer a greatest benefit to the performance of the clock distribution network (e.g., skew optimization), with less regard to the layout of the first semiconductor device tier. For instance, some of the second active devices may be arranged within a footprint of circuit blocks implemented by active devices of the first semiconductor device tier, such as registers or self-contained circuit blocks such as macros, IP blocks or non-IP block. Hence, the layout of the active clock devices may be determined more freely than had the active clock devices been implemented by the active devices of the first semiconductor device tier.

In the present disclosure, the term "active clock device" may refer to any transistor-based device of the clock distribution network, such as a clock driver, a clock repeater, a clock gate or a clock buffer (non-inverting or inverting).

While the configuration of the active clock devices according to the first aspect may be useful for all of the aforementioned types of active clock devices, it may be especially useful when applied to clock buffers. That is, arranging specifically the active devices (i.e., transistors) of the clock buffers in the second semiconductor device tier may facilitate clock tree balancing (e.g., for the purpose of skew optimization), as the locations of the clock buffers may be determined more flexibly, for the afore-mentioned reasons. Among others, this allows clock buffers to be arranged close to registers implemented by the first semiconductor device tier, with less area penalty. Additionally, the active devices of the clock buffers may be placed within the footprint of self-contained circuit blocks of the afore-mentioned types.

Accordingly, in some embodiments, the set of active clock devices comprises one or more active clock devices located within a footprint of a circuit block being any one of a register, a macro, an IP block or a non-IP block, and comprising active devices of the first set of active devices of the first semiconductor device tier.

In some embodiments, the clocked circuit comprises a set of clock inputs, each connected to an output of a respective active clock device (e.g., a respective clock buffer) of the set of active clock devices to receive the clock signal from the clock distribution network.

In some embodiments, the clocked circuit comprises a set of registers, wherein the set of clock inputs comprise clock inputs of the set of registers. Hence, registers of the clocked circuit may be connected to outputs of the active clock device (e.g., outputs of clock buffers) implemented by active devices of the second semiconductor device tier.

In some embodiments, the registers comprise flip-flops and/or latches. The present disclosure is hence applicable to both edge-triggered registers (flip-flops) and level-triggered registers (latches).

In some embodiments, the clock distribution network is a clock tree. The clock distribution network may thus be realized using one or more relatively sparsely populated metal layers of the interconnect structure.

As may be appreciated, the "first side" and the "second side" of the first semiconductor device tier may in the present disclosure refer respectively to a frontside and a backside of the first semiconductor device tier. For example, in some embodiments, the first set of active devices of the first semiconductor device tier is comprised in a first front-end-of-line (FEOL) structure of a first die of the 3D IC, wherein the first set of active device are arranged at a first side ( "frontside") of the first die, and wherein the interconnect structure comprising the plurality of clock signal routing interconnects and the second semiconductor device tier are arranged at a second side ("backside") of the first die, opposite the first side of the first die. That is, the interconnect structure comprising the clock signal routing interconnects and the second semiconductor device tier comprising the active devices of the active clock devices may each be arranged at the backside of the first die.

In some embodiments, the second set of active devices of the second semiconductor device tier is comprised in a second FEOL structure of a second die of the 3D IC device. The second set of active devices may be arranged either at a side of the second die facing the first semiconductor device tier ("first side of the second die"), or at a side of the second die facing away from the first semiconductor device tier ("second side of the second die").

Alternatively, in some embodiments, the second set of active devices are backend transistors arranged in the interconnect structure comprising the plurality of clock signal routing interconnects. In the present disclosure, the term "backend transistors" refers to BEOL-compatible transistors, i.e., transistors which may be fabricated in a BEOL-compatible process (e.g., in a low / BEOL-compatible thermal budget). For instance, the backend transistors may be thin-film transistors (TFTs) such as carbon nanotube (CNT) field-effect transistors (FETs), 2D channel FETs, oxide-semiconductor FETs.

In some embodiments, the 3D IC device further comprises a power distribution network (PDN) arranged in the interconnect structure comprising the plurality of clock signal routing interconnects, and configured to supply power to the clocked circuit and the clock distribution network. The interconnect structure may thus provide a double-function of clock and power distribution. Hence, the interconnect structure may distribute power to the active devices of the first and second semiconductor device tiers (in particular to the first and second active devices of the registers and any active clock devices), and distribute the clock signal to the second active devices of the registers and any active clock devices.

In some embodiments, the 3D IC device further comprises a first interconnect structure arranged at a side of the first semiconductor device tier facing away from the second semiconductor device tier (i.e., the first side of the first semiconductor device tier) and configured to interconnect the first set of active devices. Hence, the first set of active devices, including the first active devices of the clocked circuit, may be interconnected by the first interconnect structure. As the clock signal routing interconnects (and optionally the PDN) are arranged in the interconnect structure at the opposite second side of the first semiconductor device tier, the first set of active devices may be interconnected with less competition for routing resources with the clock distribution network (or PDN).

In some embodiments, the interconnect structure comprising the plurality of clock signal routing interconnects is a second interconnect structure and is arranged at a side of the second semiconductor device tier facing the first semiconductor device tier (i.e., first side of the second semiconductor device tier). The second interconnect structure may thus be arranged between the first and second semiconductor device tiers. The second interconnect structure may thus provide routing resources both for the first and second semiconductor device tiers. In particular, where the second interconnect structure comprises a PDN, power distribution to the first and second semiconductor device tiers may be facilitated.

In embodiments where the first and second side of the first semiconductor device tier refer, respectively, to the frontside and backside of the first semiconductor device tier, the first interconnect structure may refer to a frontside interconnect structure arranged at (e.g., on) the frontside of the first semiconductor device tier. Correspondingly, the second interconnect structure may refer to a backside interconnect structure arranged at the backside of the first semiconductor device tier.

In embodiments where the first semiconductor device tier is comprised in a first die and the first set of active device, the first interconnect structure may refer to a frontside interconnect structure arranged at (e.g., on) the frontside of the first die and the second interconnect structure may refer to a backside interconnect structure arranged at (e.g., on) the backside of the first die.

In some embodiments, the interconnect structure comprising the plurality of clock signal routing interconnects is a second interconnect structure and is arranged at a side of the second semiconductor device tier facing away from the first semiconductor device tier (i.e., the second side of the second semiconductor device tier). Thus, the clock signals may also be routed at the second side of the second semiconductor device tier (which in some embodiments may correspond to the backside of the second semiconductor device tier or, as the case may be, a second die comprising the second semiconductor device tier). In embodiments where the second interconnect structure further comprises a PDN, this applies correspondingly to the power distribution.

The 3D IC device may further comprise a third interconnect structure arranged at the side of the second semiconductor device tier facing the first semiconductor device tier (i.e., the first side of the second semiconductor device tier) and configured to interconnect the second set of active devices. Hence, the second set of active devices, including the active devices of the active clock devices, may be interconnected by the third interconnect structure at the first side (e.g.., frontside) of the second semiconductor device tier. As the clock signal routing interconnects (and optionally the PDN) are arranged in the second interconnect structure at the opposite second side (e.g., backside) of the second semiconductor device tier, the second set of active devices may be interconnected with less competition for routing resources with the clock distribution network (and PDN).

The principles of the present disclosure are applicable also to multi-tier IC designs, comprising more than two semiconductor device tiers.

Hence, in some embodiments, the 3D IC device further comprises a third semiconductor device tier comprising a third set of active devices, wherein the clocked circuit is a first clocked circuit, and the 3D IC device further comprises a second clocked circuit comprising third active devices comprised in the third set of active devices of the third semiconductor device tier, and wherein the second clocked circuit is connected to the clock distribution network to receive a clock signal.

Hence, the second semiconductor device tier may be used to implement the active clock devices of a clock distribution network shared between the first and second clocked circuits.

In some embodiments, the second clocked circuit comprises a set of clock inputs, each connected to an output of a respective active clock device of the set of active clock devices to receive the clock signal from the clock distribution network.

### BRIEF DESCRIPTION OF THE DRAWINGS

The above, as well as additional objects, embodiments, features and effects of the present disclosure, may be better understood through the following illustrative and non-limiting detailed description, with reference to the appended drawings. In the drawings like reference numerals will be used for like elements unless stated otherwise.
Fig. 1 schematically shows a cross-section of a 3D IC device.
Fig. 2 is a schematic block diagram of a circuit configuration of the 3D IC device of Fig. 1.
Fig. 3a-b shows, respectively, a schematic perspective view of the 3D IC device of Fig. 2, and a distribution of clock buffers and registers between first and second circuit tiers, respectively.
Fig. 4 schematically shows a cross-section of a further 3D IC device.
Fig. 5 is a schematic block diagram of a circuit configuration of the 3D IC device of Fig. 4.

### DETAILED DESCRIPTION

Example embodiments of a 3D integrated circuit (IC) or 3D IC device will in the below be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X and Y consistently refer to a horizontal direction and a vertical direction, respectively. As used herein, the term "horizontal" refers to a direction parallel to a main plane of extension of a device tier, a die or substrate of the 3D IC. The term "vertical" refers to a direction parallel to a normal direction to the main plane of extension of a device tier, die or substrate, i.e., transverse to the horizontal direction. In other words, "horizontal" and "vertical" refer respectively to in-plane and out-of-plane directions with respect to a device tier, die or substrate. In the present disclosure, when an element (e.g. a die or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element. In the present disclosure, when two elements are said to be "connected" or "interconnected" it is meant that the elements are electrically connected or coupled, directly or via one or more intermediate conductive structures (e.g., interconnects), unless stated otherwise.

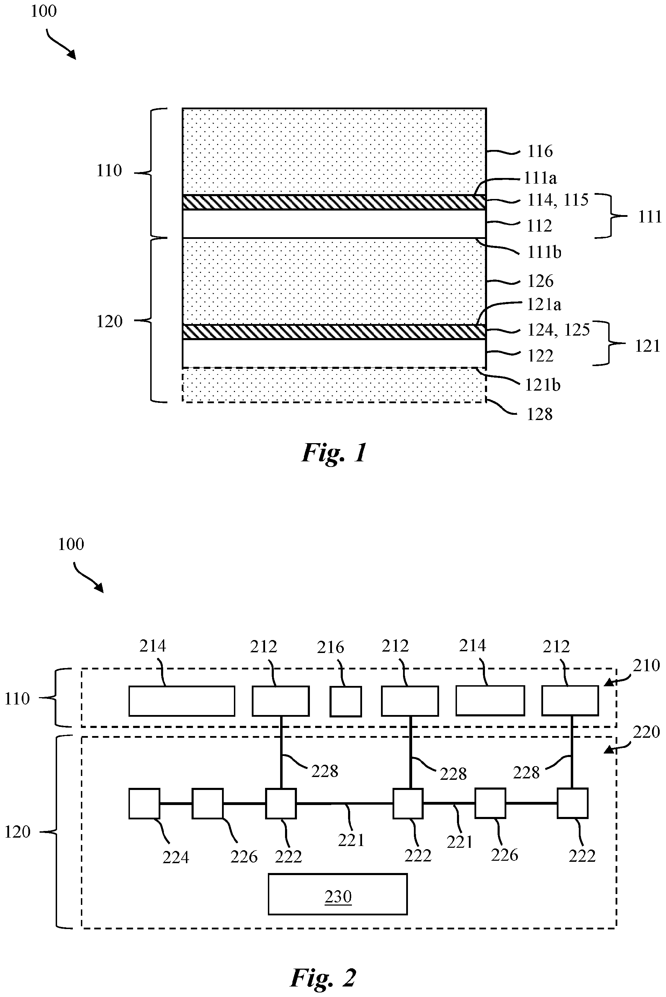

Fig. 1 shows a schematic cross-section of a 3D IC device 100 in accordance with some embodiments of the present disclosure. The IC device 100 comprises a stack of circuit tiers including a first circuit tier 110 and a second circuit tier 120. The first circuit tier 110 is stacked on top of, i.e., arranged above, the second circuit tier 120, as seen along the Y direction. While Fig. 1 shows two circuit tiers 110, 120, the first and second circuit tiers 110, 120 may more generally be two circuit tiers of a plurality of stacked circuit tiers. As further described in the following, the first and second circuit tiers 110, 120 may in some implementations correspond to first and second dies, respectively, of a stack of dies.

The first circuit tier 110 comprises a first semiconductor device tier 111 (hereinafter abbreviated "device tier"). The second circuit tier 120 comprises a second device tier 121. The first circuit tier 110 comprises a first set of active devices 115. The second circuit tier 120 comprises a second set of active devices 125. The first device tier 111 may, as indicated in Fig. 1, comprise a substrate 112 and a front-end-of-line (FEOL) structure 114 arranged or formed on the substrate 112 and comprising the first set of active devices 115. The first set of active devices 115 may thus be referred to as frontend transistors of the FEOL structure 114. The second device tier 121 may have a corresponding structure, and thus comprise a substrate 122 (corresponding to the substrate 112) and a FEOL structure 124 (corresponding to the FEOL structure 114) arranged or formed on the substrate 122 and comprising the second set of active devices 115. The second set of active devices 125 may thus be referred to as frontend transistors of the FEOL structure 124. The substrates 112, 122 may each be a conventional semiconductor substrate, suitable for CMOS circuits and semiconductor device processing, for instance a semiconductor substrate of Si, Ge or SiGe. Other non-limiting examples include a silicon-on-insulator (SOI) substrate, a GeOI substrate or a SiGeOI substrate. By the term "FEOL structure" is herein meant a layer, tier or vertical section of an IC device comprising an active semiconductor layer (i.e., comprising the active regions or patterns of the active devices / transistors) and a gate layer (i.e., comprising the gates of the active devices). The active regions may comprise S/D regions and channel regions of the active devices. The FEOL structure may further comprise a local contact or interconnect layer (i.e., comprising the source/drain (S/D) contacts of the active devices). While referred to as a single layer, the local contact layer may typically comprise (at least) two metal layers: a bottom layer ("contact-to-active" or "trench silicide") and a top or "plug" layer (e.g. of TiN, Co, Ru and/or W). The active devices of the FEOL structure may comprise NMOSFETs and PMOSFETs, for instance realized as horizontal channel FETs, such as FinFETs, nanosheet FETs or nanowire FETs. The active semiconductor layer may be formed by semiconductors such as Si, Ge or SiGe, or other bulk / 3D semiconductors conventionally used to realize CMOS devices. The active semiconductor layer may be formed on a substrate, or in a thickness portion of a substrate, e.g. the respective substrate 112 or 122 in the depicted example.

The IC device 100 further comprises a first and second interconnect structure 116, 126, e.g., a back-end-of-line (BEOL) interconnect structure. By the term "BEOL interconnect structure" (or simply "interconnect structure") is herein meant a vertical stack of interconnect layers, each comprising interconnects, (typically of metal) such as horizontally routed interconnects (conductive traces or lines) or vertically routed interconnects ("vias"), embedded in interlayer dielectrics. An interconnect layer of horizontally routed interconnects may be referred to as a "metal routing layer" (or simply "routing layer"). An interconnect layer of vertically routed interconnects may be referred to as a via layer. A via layer may thus provide vertical routing of signals between different metal routing layers, or between a routing layer and conductive elements of the FEOL structure (e.g., gates or S/D contacts).

The first interconnect structure 116 is arranged at a first side 111a of the first device tier 111. The first side 111a is as shown the side of the first device tier 111 facing away from the second device tier 121. The second interconnect structure 126 is arranged at a second side 11 1b of the first device tier 111. The second side 11 1b is as shown the opposite side of the first device tier 111 facing the second device tier 121. The second interconnect structure 126 is thus arranged between the first and second device tiers 111, 121. In the illustrated example, the first side 111a defines a frontside 111a of the FEOL structure 114 and the first device tier 111 whereas the second side 111b defines a backside 11 1b of the FEOL structure 114 and the first device tier 111. Thus, with respect to the FEOL structure 114 and the first device tier 111, the first interconnect structure 116 may be referred to as a (first) frontside interconnect structure 116 and the second interconnect structure 126 may be referred to as a backside interconnect structure 126.

In Fig. 1, the first device tier 111 and the first/frontside interconnect structure 116 are shown to be comprised in the first circuit tier 110, while the second device tier 121 and the second/backside interconnect structure 126 are shown to be comprised in the second circuit tier 120. In some implementations, the illustrated partitioning of the IC device 100 into the first and second circuit tiers 110, 120 may correspond to an actual structural and/or manufacturing-related partitioning of the IC device 100. For example, where the IC device 100 comprises a stack of dies, the first and second circuit tiers 110, 120 may correspond respectively to a first and a second die. In the present disclosure, the term "die" is used to refer to a die structure or chip of an IC device. Thus, the first (semiconductor) device tier 111 (e.g., comprising the substrate 112 and the FEOL structure 114) may be a device tier of the first die, and the first interconnect structure 116 may be a frontside interconnect structure of the first die. Correspondingly, the second (semiconductor) device tier 121 (e.g., comprising the substrate 122 and the FEOL structure 124) may be a device tier of the second die, and the second interconnect structure 126 may be a frontside interconnect structure of the second die. The first and second circuit tiers/dies 110, 120 may be fabricated and subsequently be stacked and bonded with the second interconnect structure 126 facing the backside 111b of the first die (i.e., face-to-back). Thus, while the second interconnect structure 126 in this example is fabricated at a frontside of the second die, it may after stacking and bonding define a backside interconnect structure 126, with respect to the first die. The stack of dies may be formed using any one of die-to-die bonding, wafer-to-die bonding or wafer-to-wafer bonding.

In a further example, a first portion (i.e., a first subset of interconnect layers) of the second interconnect structure 126 may be formed during backside processing of the first die/wafer and a second portion (i.e., a second subset of interconnect layers) of the second interconnect structure 126 may be formed during frontside processing of the second die/wafer. In this case, the second interconnect structure 126 may be formed during bonding of the first and second dies/wafers, by bonding the first and second portions of the second interconnect structure 126, thereby forming a common / composite second interconnect structure 126 defining the backside interconnect structure 126 with respect to the first die. As another example, the second interconnect structure 126 may be exclusively formed during backside processing of the first die/wafer and subsequently the first and second dies may be bonded with the second interconnect structure 126 to the second device tier 111 of the second die.

Furthermore, in the illustrated example, each of the first and second device tiers 111, 121 comprise a respective substrate 112, 122. However, as per se is known the art, it is possible to perform substrate or wafer thinning during device fabrication, to provide access to the active devices (e.g., source/drain contacts) from a backside. Thus, prior to bonding, the substrates 112, 122 may be thinned. In case of extreme substrate thinning, the substrate(s) may be substantially removed such that only the FEOL structure 114 or 124 remains in the finished IC device 100. Thus, the substrates 112, 122 shown in Fig. 1 may in some implementations be regarded as optional.

In a further example, the first and second dies may be bonded back-to-back, such that the frontside 121a of the second device tier 121 faces away from the first device tier 111. In this case, the second interconnect structure 126 may in analogy with the above device fabrication examples be formed by: a backside interconnect structure of the second die/wafer formed exclusively during backside processing of the first die/wafer and subsequently bonded to the backside of the second die/wafer; a second portion of the second interconnect structure 126 formed during backside processing of the second die/wafer and a corresponding first portion of the second interconnect structure 126 formed during backside processing of the first die/wafer and subsequently bonded to the second portion; or a backside interconnect structure of the first die/wafer formed exclusively during backside processing of the first die/wafer and subsequently bonded to the backside of the second die/wafer.

In yet a further example, the second device tier 121 may be realized by backend transistors arranged in the second/backside interconnect structure 126. Examples of backend transistors include TFTs, such as CNT FETs and/or 2D channel FETs. A CNT FET is a transistor device comprising a channel structure of one or more CNTs. A 2D channel FET is a transistor device comprising a channel structure of a 2D semiconductor. Examples of 2D semiconductors include transition metal dichalcogenides (TMDs), IGZO, IGO, and other suitable 2D semiconductors conventionally used to realize backend transistors. The backend transistors may for example be formed during backside processing of the first die/wafer. Fabrication of backend transistors may comprise process techniques which per se are known in the art, such as deposition of channel material on top of an interconnect layer of a (BEOL) interconnect structure, patterning and doping the channel material to form channel regions and S/D regions, gate stack and S/D contact deposition, etc. After completing formation of the backend transistors, further interconnect layers may be processed on top of backend transistors, e.g., to form interconnects for the backend transistors and/or interconnects of a backside power distribution network (PDN), etc. Fabrication techniques which may be used to form the backend transistors include 3D sequential techniques (sometimes referred to as monolithic 3D integration) involving blanket active layer transfer onto a prefabricated FEOL structure and (a lower part of) an interconnect structure. In a monolithic 3D integration, the backend transistors need to be fabricated at a low thermal budget to avoid degradation of the frontend transistors of the FEOL structure 4, typically below 500 °C. Thus, backend transistors may advantageously be BEOL-compatible devices. Further details concerning fabrication and integration of backend transistors are per se known in the art and will hence not be further described herein.

In each of the above-mentioned example implementations, the second interconnect structure 126 is arranged between the first and second device tiers 111, 121 and may be referred to as a backside interconnect structure 126 with respect to the first device tier 111 and first FEOL structure 114. Correspondingly, the second circuit tier 120 may be referred to as a backside circuit tier 120 with respect to the first device tier 111 and the first circuit tier 110.

Fig. 2 is a schematic block diagram showing in a schematic manner a circuit configuration of the 3D IC device 100. As shown in Fig. 2, the IC device 100 comprises a clocked circuit 210 and a clock distribution network 220 connected to the clocked circuit 210. The clocked circuit 210 is comprised in the first circuit tier 110. The clock distribution network 220 is comprised in the second circuit tier 120. The clocked circuit 210 comprises a number of circuit portions or circuit blocks 212, 214, 216, at least some of which are synchronous circuits clocked by the clock distribution network 220. Each of the circuit blocks 212, 214, 216 comprise first active devices (transistors) comprised in the first set of active devices 115 of the first device tier 111. That is, the first active devices refers to any active devices / transistors (typically a subset) of the first device tier 111 (e.g., the first FEOL structure 114) comprised in the clocked circuit 210. For ease of explanation, the same reference signs 212, 214, 216 may in the following be used to refer to respective circuit blocks of the clocked circuit 210 and the first active devices comprised in / implementing the respective circuit blocks.

The clock distribution network 220 comprises a set of active clock devices 222, 224, 226 formed by second active devices (transistors) comprised in the second set of active devices 125 of the second device tier 121. That is, the second active devices refer to any active devices / transistors (typically a subset) of the second set of active devices 125 (e.g., the second FEOL structure 124) comprised in the set of active clock devices. For ease of explanation, the same reference signs 222, 224, 226 may in the following be used to refer to respective active clock devices of the clock distribution network 220 and the second active devices comprised in / implementing the respective active clock devices. The clock distribution network 220 further comprises a plurality of clock signal routing interconnects arranged in the second / backside interconnect structure 126, schematically indicated by the horizontally oriented lines 221. The clock signal routing interconnects 221 may be realized using a combination of routing layers and via layers of the backside interconnect structure 126. The clock signal routing interconnects 221 further comprises inter-tier interconnects connected to the clocked circuit 210 of the first circuit tier 110 for vertically routing the clock signal between the first and second circuit tiers 110, 120. The inter-tier interconnects are in Fig. 2 schematically indicated by the vertically oriented lines 228. The specific implementation of inter-tier interconnects may depend on the device technology used to realize the IC device 100. For example, in the case of a 3D sequential fabrication process, the inter-tier interconnects may be implemented by a combination of horizontally routed interconnects of one or more metal routing layers, vias of one or more via layers of the backside interconnect structure 126, and inter-tier contacts. In the case of die/chip stacking, the inter-tier contacts may be implemented by backside contacts, or hybrid bond pads, i.e., bonded pads of the first and second dies. Where the first device tier 111 comprises a substrate 112, the inter-tier contacts may further comprise through-silicon vias (TSVs), extending through the substrate 112 and connected to the active devices 115 of the first FEOL structure 114. In the present disclosure, the term "TSV" refers to a via structure (i.e., a vertical electrical interconnect) extending through a substrate of a die, regardless of the type of semiconductor material of the substrate, consistent with its typical usage in the semiconductor industry.

The clock distribution network 220 may for example be implemented as a clock tree (e.g., an H-tree). However, also other topologies are possible, such as a clock mesh, a clock spine, a clock fishbone, a serpentine architecture, or combinations thereof. The active clock devices of the clock distribution network 220 may include active clock devices 222, 224, 226 such as clock drivers, clock repeaters, clock gates, clock dividers, clock multiplexers, and/or clock buffers (input/output buffers and balancing buffers). For example, reference signs 224 and 226 may represent any one of a clock driver, a clock repeater, a clock gate, a clock divider, a clock multiplexer, or a clock tree balancing buffer. Further, reference sign 222 may represent a clock buffer 222 configured as a clock signal output connected to one or more corresponding clock signal inputs of the clocked circuit 210.

The clocked circuit 210 may comprise a set of clock inputs, each connected to an output of a clock buffer 222 to receive the clock signal from the clock distribution network 220. Each clock input may be connected to a respective synchronous circuit portion or circuit block of the clocked circuit 210. The clocked circuit 210 may include various combinations of registers, macros, IP blocks and/or non-IP blocks, each implemented by a subset of the first set of active devices 115 of the first device tier 111.

For example, reference sign 214 may represent any one of a macro, an IP block, or a non-IP block. Reference sign 216 may represent some other logic circuit block, such as a combinational logic circuit block. Reference sign 212 may represent a register. Each register 212 may comprise flip-flops and/or latches. Each register 212 may comprise one or more clock inputs, each connected to a corresponding clock output of the clock distribution network 220. In particular, a clock input of a register 212 may as shown be connected to a clock output of a clock buffer 222 of the clock distribution network 220. While not expressly shown in Fig. 2, the registers 212 may be connected to other circuit blocks 214, 216 of the clocked circuit 210, to receive, store and supply data processed by the clocked circuit 210.

As suggested by Fig. 2, a merit of implementing active clock devices 222, 224, 226 in the second device tier 121 of the second / backside circuit tier 120, is that the active clock devices 222, 224, 226 may be placed flexibly, with less regard to the layout of circuit blocks 212, 214, 216 of the clocked circuit 210 of the first circuit tier 110. For instance, clock drivers, clock repeaters, clock gates, and/or clock buffers 222, 224, 226 may be provided at the locations in the backside circuit tier 120 where they confer a greatest benefit to the performance of the clock distribution network 220. In a conventional implementation of a backside clock distribution network, the active clock devices are implemented by active devices / transistors of the same device tier (e.g., of a same die) as the clocked / synchronous logic and memory circuits. Hence, the floorplan of the circuit needs to be designed such that there is space (e.g., die area) to accommodate the active clock devices alongside the logic and memory circuits. In contrast, in accordance with the present disclosure, since the first active devices 115 implementing the circuit blocks 212, 214, 216 of the clocked circuit 210 and the second active devices 125 implementing the active clock devices 222, 224, 226 are arranged in different circuit and device tiers 110/111 and 120/121, the active clock devices 222, 224, 226 may be arranged within a footprint of the circuit blocks 212, 214, 216 of the clocked circuit 210. A related benefit applicable specifically to the clock buffers 222 is that the clock buffers 222 may be arranged close to connected registers 212, with less area penalty. More specifically, a clock buffer 222 may as shown in Fig. 2 be arranged within the footprint of (e.g., be overlapped by) a connected register 212. The reduced area penalty follows from that the active devices of the clock buffers 222 not taking up any footprint in the first device tier 111, and further from that fewer connections between the clock distribution network 220 and the first device tier 111 are needed compared to had the transistors of all of the active clock devices, as is in the conventional implementation, been arranged in the first semiconductor device tier 111.

With further reference to Fig. 2, the clock distribution network 220 may be co-integrated with a power distribution network (PDN) 230 in the backside circuit tier 120 and the backside interconnect structure 126. The PDN 230 is in Fig. 2 indicated in a highly schematic manner, but may, as would be understood by the skilled person, comprise a plurality of power rails (e.g., VDD and VSS) in the backside interconnect structure, and configured to supply power to the clocked circuit 210 and the clock distribution network 220. Consistent with denoting the second circuit tier 120 and the second interconnect structure 126 as a backside circuit tier 120 and a backside interconnect structure 126, the PDN 230 may be referred to as a backside PDN 230, i.e., with respect to the first device tier 111 and the first circuit tier 110.

In addition to the interconnects of the backside interconnect structure 126 discussed above (e.g., the clock signal routing interconnects 221, power rails of the PDN 230, etc.) the backside interconnect structure 126 further may comprise interconnects (e.g., in one or more metal routing and via layers) configured for signal routing between the second active devices 125 of the active clock devices 222, 224, 226. That is, the backside interconnect structure 126 may be further configured to interconnect the second active devices 125 of the active clock devices 222, 224, 226.

In the above discussion, reference has been made only to a single backside interconnect structure 126 of the backside circuit tier 120, wherein the backside interconnect structure 126 comprises the clock signal routing interconnects 221 of the clock distribution network 120. However, as shown in Fig. 1, the backside circuit tier 120 may comprise a further backside interconnect structure 128, arranged at the opposite side 121b of the second device tier 121, e.g., the backside of the second device tier 121. This enables further implementation options for the backside routing of the clock. In implementations comprising both backside interconnect structures 126 and 128, the interconnect structure 116 of the first circuit tier 110 may be referred to as a first interconnect structure 116, the interconnect structure 128 of the backside circuit tier 120 may be referred to as a second interconnect structure 128 ("backside interconnect structure 128"), and the interconnect structure 126 may be referred to as a third interconnect structure 126 ("backside interconnect structure 126"). The backside interconnect structure 128 thus refers to an interconnect structure of the backside circuit tier 120 arranged at the backside 121b of the first device tier 121, while the backside interconnect structure refers to an interconnect structure of the backside circuit tier 120 arranged at the frontside 121a of the second device tier 121, i.e., between the first and second active device tiers 111, 121. In this configuration, a first subset of the clock signal routing interconnects 221 may be comprised in the backside interconnect structure 128, such that the clock signal may be routed at the backside of the second device tier 121. Further, a second subset of the clock signal routing interconnects 221 may be comprised in the backside interconnect structure 126. The first and second subset of clock signal routing interconnects 221 may be connected through the second device tier 121 by TSVs, for example. The backside interconnect structure 126 may further comprise the inter-tier interconnects 228.

Having both backside interconnect structures 126, 128 also enables further implementation options for the backside power distribution. For instance, the backside PDN 230 of Fig. 2 may in this case comprise a first set of power rails arranged in the backside interconnect structure 128 and configured to supply power to the clock distribution network 220, and further a second set of power rails arranged in the backside interconnect structure 126 and configured to supply power to the clocked circuit 210.

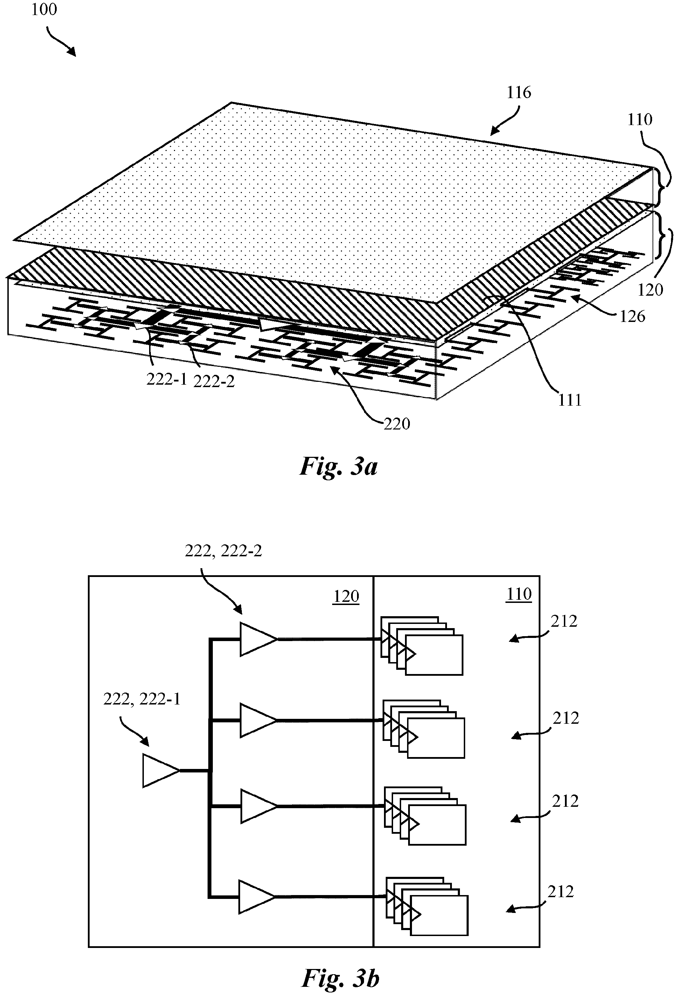

Fig. 3a-b shows, respectively, a schematic perspective view of the IC device 100 of Fig. 1 and 2, and a distribution of clock buffers 222 and registers 212 between the first and second circuit tiers 110, 120. In Fig. 3a, the clock distribution network 220 is depicted in an H-tree implementation. In Fig. 3b, the clock buffers 222 are exemplified by a first clock buffer 222-1 with a fan-out (FO) of FO = 4 and connected to a set of second clock buffers 222-2 with a fanout of FO = 8 which in turn are connected to a respective set of registers 212 here by way of example depicted as flip-flops. The first and second clock buffers 222-1, 222-2 may for example have a drive strength of 16 and 8, respectively.

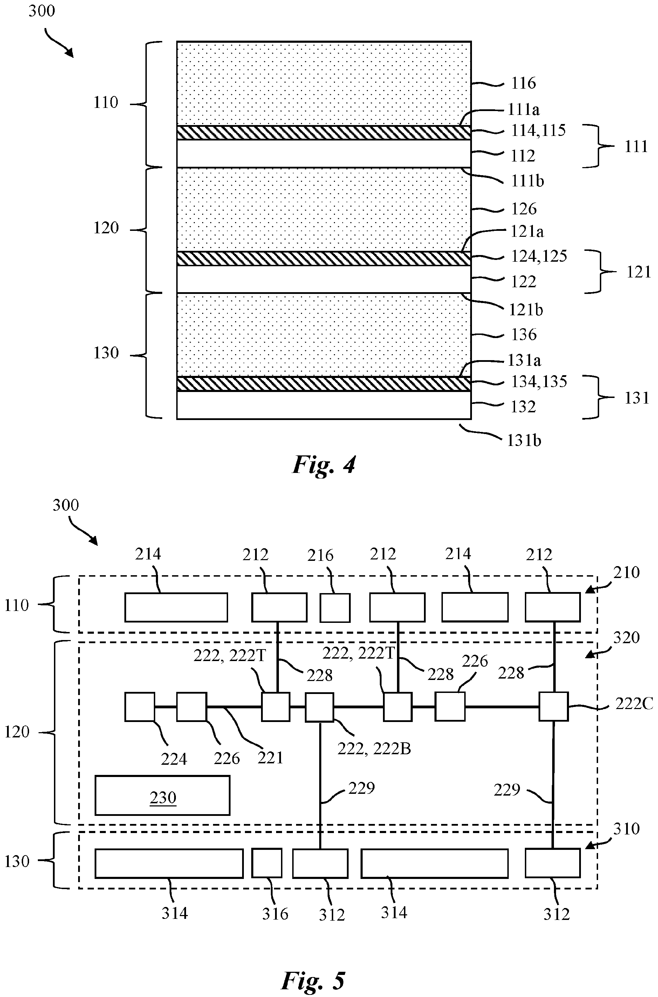

Fig. 4 schematically shows a schematic cross-section of a further IC device 300 in accordance with some embodiments of the present disclosure. The IC device 300 comprises like the IC device 100 of Fig. 1 a stack of circuit tiers including a first circuit tier 110 and a second circuit tier 120. The first and second circuit tiers 110, 120 of the IC device 300 generally correspond to the first and second circuit tiers 110, 120 of the IC device 100 of Fig. 1. Hence, to avoid undue repetition, for a description of the features of the first and second circuit tiers 110, 120 of the IC device 300, reference is made to the discussion of the correspondingly numbered features in Fig. 1.

The IC device 300 differs from the IC device 100 by further comprising a third circuit tier 130. The third circuit tier 130 generally corresponds to the first circuit tier 110 and comprises a third semiconductor device tier 131 comprising a third set of active devices 135. The third device tier 131 may as shown, in analogy with the first device tier 111, comprise a substrate 132 and a FEOL structure 134 arranged or formed on the substrate 132 and comprising the third set of active devices 135. The third set of active devices 135 may thus be referred to as frontend transistors of the FEOL structure 134. The first, second and third circuit tiers 110, 120, 130 may, analogous to the discussion of the first and second circuit tiers 110, 120 of the IC device 100 of Fig. 1, correspond to a first, second and third die, arranged to form a stack of dies. Additionally, as described with reference to the second device tier 121 of the IC device 100, the substrate 132 of the third device tier 131 need not be present, if removed by substrate thinning during device fabrication.

The third circuit tier 130 further comprises a third BEOL interconnect structure 136. The third interconnect structure 136 is arranged at a first side 131a of the third device tier 131. The first side 131a is as shown the side of the third device tier 131 facing away from the third device tier 131. In the illustrated example, the first side 131a defines a frontside 131a of the FEOL structure 134 and the third device tier 131. Thus, with respect to the FEOL structure 134 and the third device tier 131, the third interconnect structure 136 may be referred to as a (third) frontside interconnect structure 136, the third interconnect structure 136 is configured to interconnect the third set of active devices 135, in particular to implement a further clocked circuit 310 of the third circuit tier 130 further described below with reference to Fig. 5.

Similar to the preceding discussion of the circuit tiers 110, 120 of the IC device 100 of Fig. 1, the illustrated partitioning of the IC device 300 into the first, second and third circuit tiers 110, 120, 130 may, but need not, correspond to an actual structural and/or manufacturing-related partitioning of the IC device 300. For example, where the IC device 300 comprises a stack of dies, the first, second and third circuit tiers 110, 120, 130 may correspond respectively to a first, second and third die. Thus, the first device tier 111 may be a device tier of the first die, and the first interconnect structure 116 may be a frontside interconnect structure of the first die. The second device tier 121 may be a device tier of the second die, and the second interconnect structure 126 may be a frontside interconnect structure of the second die. The third device tier 131 may be a device tier of the third die, and the third interconnect structure 136 may be a frontside interconnect structure of the third die. The first, second and third circuit tiers/dies 110, 120, 130 may thus be fabricated on respective wafers, and subsequently be stacked and bonded with the second interconnect structure 126 facing the backside 111b of the first die (i.e., face-to-back), and the third interconnect structure 136 facing the backside 121b of the second die. Thus, while the second and third interconnect structures 126, 136 in this example are fabricated at a respective frontside of the second and third dies, respectively, they may after stacking and bonding define backside interconnect structures with respect to the first die. However, analogous to the preceding discussion of the IC device 100, other fabrication approaches are also possible. For instance, a first portion (i.e., a first subset of interconnect layers) of the third interconnect structure 136 may be formed during backside processing of the second die/wafer and a second portion (i.e., a second subset of interconnect layers) of the third interconnect structure 136 may be formed during frontside processing of the third die/wafer. In this case, the third interconnect structure 136 may be formed during bonding of the second and third dies/wafers, by bonding the first and second portions of the third interconnect structure 136, thereby forming a common / composite third interconnect structure 136 defining a backside interconnect structure 136 with respect to the first and second dies. As another example, the third interconnect structure 136 may be formed during backside processing of the second die/wafer and subsequently the second and third dies may be bonded with the third interconnect structure 136 to the third device tier 131 of the third die. As another example, while in Fig. 4 the frontside 131a of the third device tier 131 is facing the first and second device tiers 111, 121, an opposite orientation is also possible. That is, the third device tier 131 may be arranged with its backside 131b facing the facing the first and second device tiers 111, 121. The third interconnect structure 136 may in this case define a backside interconnect structure also with respect to the third device tier 131. In this case, the third circuit tier 130 may typically comprise a further frontside interconnect structure arranged at the frontside 131a of the third device tier 131 and configured to interconnect the third set of active devices 135, e.g., to implement the second clocked circuit 310.

Fig. 5 is a schematic block diagram showing in a schematic manner a circuit configuration of the 3D IC device 300. As shown in Fig. 5, the IC device 300 comprises a first clocked circuit 210 comprised in the first circuit tier 110, a second clocked circuit 310 comprised in the third circuit tier 130, and a clock distribution network 320. In the illustrated example, the clock distribution network 320 is comprised in both the second and third circuit tiers 120, 130 as further described in the following.

The first clocked circuit 210 corresponds to the clocked circuit 210 of the IC device 100 of Fig. 2. The second clocked circuit 310, like the first clocked circuit 210, comprises a number of circuit portions or circuit blocks 312, 314, 316, at least some of which are synchronous circuits clocked by the clock distribution network 320. Each of the circuit blocks 312, 314, 316 comprise third active devices (transistors) comprised in the third set of active devices 135 of the third device tier 131. That is, the third active devices refers to any active devices / transistors (typically a subset) of the third device tier 131 (e.g., the FEOL structure 134) comprised in the second clocked circuit 310. For ease of explanation, the same reference signs 312, 314, 316 may in the following be used to refer to respective circuit blocks of the second clocked circuit 310 and the third active devices comprised in / implementing the respective circuit blocks. The second clocked circuit 310 may, like the first clocked circuit 210, comprise a set of clock inputs, each connected to a clock output of the clock distribution network 320 to receive the clock signal from the clock distribution network 320. Each clock input may be connected to a respective synchronous circuit portion or circuit block of the clocked circuit 310. The clocked circuit 310 may include various combinations of registers, macros, IP blocks and/or non-IP blocks, each implemented by a respective subset of the third set of active devices 135 of the third device tier 131. For example, reference sign 314 may represent any one of a macro, an IP block, or a non-IP blocks. Reference sign 316 may represent some other logic circuit block, such as a combinational logic circuit block 316. Reference sign 312 may represent a register. Each register 312 may comprise flip-flops and/or latches. Each register 312 may comprise one or more clock inputs, each connected to a corresponding clock output of the clock distribution network 320. While not expressly shown in Fig. 5, the registers 312 may be connected to other circuit blocks 314, 316 of the second clocked circuit 310, to receive, store and supply data processed by the second clocked circuit 310.

The clock distribution network 320 generally corresponds to the clock distribution network 220 of the IC device 100, and accordingly comprises a set of active clock devices such as clock input/output buffers 222, clock drivers/repeaters/gates/balancing buffers 224, 226. The active clock devices 222, 224, 226 are formed by second active devices (transistors) comprised in the second set of active devices 125 of the second device tier 121. The clock distribution network 320 further comprises clock signal routing interconnects 221. The clock signal routing interconnects 221 may comprise a first and second subset of clock signal routing interconnects 221 comprised in the second interconnect structure 126 of the second circuit tier 120 and the third interconnect structure 136 of the third circuit tier 130, respectively. The clock distribution network 320 further comprises first and second inter-tier interconnects 228, 229. The first inter-tier interconnects 228 are comprised in the second interconnect structure 126 and connected to the first clocked circuit 210 of the first circuit tier 110 for vertically routing the clock signal between the first and second circuit tiers 110, 120. The second inter-tier interconnects 229 are comprised in the third interconnect structure 136 and connected to the second clocked circuit 310 of the third circuit tier 130 for vertically routing the clock signal between the second and third circuit tiers 120, 130.

In particular, the clock distribution network 230 may comprise first clock buffers 222T connected to clock inputs of registers 212 of the first circuit tier 110. The clock distribution network 230 may further comprise second clock buffers 222B connected to clock inputs of registers 312 of the third circuit tier 130. The clock distribution network 230 may further comprise third clock buffers 222C connected both to clock inputs of registers 212 of the first circuit tier 110, and to clock inputs of registers 312 of the third circuit tier 130.

The clock distribution network 320 may further, like the clock distribution network 220 of the IC device 100, be co-integrated with a PDN 230 in the second circuit tier 120 and the second interconnect structure 126.

Accordingly, as demonstrated by Fig. 5, in accordance with some implementations of the present disclosure, a clock distribution network 320 and, optionally, the PDN 230, may be shared by clocked circuits 210, 220 of two surrounding circuit tiers 110, 120.

The person skilled in the art realizes that the present invention by no means is limited to the examples described above. On the contrary, many modifications and variations are possible within the scope of the appended claims. For example, in the illustrated examples discussed above, each of the active clock devices, including clock drivers, clock repeaters, clock gates and/or input/output/balancing clock buffers of the clock distribution networks 220, 320 are implemented by active devices of the second device tier 121. However, it is also possible to distribute the active clock devices of the clock distribution networks 220, 320 between the different circuit tiers (for clock distribution network 220 between circuit tiers 110, 120, and for clock distribution network 320 between circuit tiers 110, 120, 130). Thus, only some of the active clock devices of the clock distribution networks 220, 320 may be implemented by the second set of active devices 125 of the second device tier 121, and the other active clock devices may be implemented by the first and/or third set of active devices 115, 135 of the first and/or third device tiers 111, 131. In general, it may be beneficial to implement at least the clock buffers (input/output/balancing) of the clock distribution networks 220, 320 by the second set of active devices 125 of the second device tier 121. This since, the above-discussed benefit of facilitating clock tree balancing may be maintained. Additionally, since the connections between clock buffers 222 and registers 212, 312 typically outnumber the connections to the clock drivers or clock gates, it is contemplated this may further provide the greatest contribution to a reduced area penalty of backside routing of the clock.

## Claims

1. A 3D integrated, IC, device (100) comprising:
a first semiconductor device tier (111) comprising a first set of active devices (115);
a second semiconductor device tier (121) comprising a second set of active devices (125);
a clocked circuit (210) comprising first active devices (212) comprised in the first set of active devices (115) of the first semiconductor device tier (111); and
a clock distribution network (220) comprising a plurality of clock signal routing interconnects (221) arranged in an interconnect structure (126, 128) arranged at a side (111b) of the first semiconductor device tier (111) facing the second semiconductor device tier (121), and a set of active clock devices (222, 224, 226) formed by second active devices comprised in the second set of active devices (125) of the second semiconductor device tier (121);
wherein the clocked circuit (210) is connected to the clock distribution network (220) to receive a clock signal.

2. The 3D IC device (100) according to claim 1, wherein the set of active clock devices (222, 224, 226) comprises clock buffers (222).

3. The 3D IC device (100) according to any one of the preceding claims, wherein the set of active clock devices (222, 224, 226) comprises one or more active clock devices located within a footprint of a circuit block (212, 214) being any one of a register, a macro, an IP block or a non-IP block, and comprising active devices of the first semiconductor device tier (111).

4. The 3D IC device (100) according to any one of the preceding claims, wherein the clocked circuit (210) comprises a set of clock inputs, each connected to an output of a respective active clock device (222) of the set of active clock devices to receive the clock signal from the clock distribution network (220).

5. The 3D IC device (100) according to claim 4, wherein the clocked circuit (210) comprises a set of registers (212), wherein the set of clock inputs comprise clock inputs of the set of registers (212).

6. The 3D IC device (100) according to claim 5, wherein the registers (212) comprise flip-flops and/or latches.

7. The 3D IC device (100) according to any one of the preceding claims, wherein the clock distribution network (220) is a clock tree.

8. The 3D IC device (100) according to any one of the preceding claims, further comprising a power distribution network (230) arranged in the interconnect structure (126) comprising the plurality of clock signal routing interconnects (221), and configured to supply power to the clocked circuit (210) and the clock distribution network (220).

9. The 3D IC device (100) according to any one of the preceding claims, further comprising a first interconnect structure (116) arranged at a side (1 11a) of the first semiconductor device tier (111) facing away from the second semiconductor device tier (121) and configured to interconnect the first set of active devices (115).

10. The 3D IC device (100) according to claim 9, wherein the interconnect structure (126) comprising the plurality of clock signal routing interconnects (221) is a second interconnect structure (126) and is arranged at a side (121a) of the second semiconductor device tier (121) facing the first semiconductor device tier (111).

11. The 3D IC device (100) according to claim 9, wherein the interconnect structure (128) comprising the plurality of clock signal routing interconnects (221) is a second interconnect structure (128) and is arranged at a side (121b) of the second semiconductor device tier (121) facing away from the first semiconductor device tier (111), and
wherein the 3D IC device (100) further comprises a third interconnect structure (126) arranged at the side (121a) of the second semiconductor device tier (121) facing the first semiconductor device tier (111) and configured to interconnect the second set of active devices (125).

12. The 3D IC device (300) according to any one of the preceding claims, further comprising a third semiconductor device tier (131) comprising a third set of active devices (135), wherein the clocked circuit (210) is a first clocked circuit (210), and the 3D IC device (300) further comprises a second clocked circuit (310) comprising third active devices (312) comprised in the third set of active devices (135) of the third semiconductor device tier (131), and wherein the second clocked circuit (301) is connected to the clock distribution network (220) to receive a clock signal.

13. The 3D IC device (300) according to claim 12, wherein the second clocked circuit (310) comprises a set of clock inputs, each connected to an output of a respective active clock device of the set of active clock devices (228) to receive the clock signal from the clock distribution network (220).

14. The 3D IC device (100) according to any one of the preceding claims, wherein the first set of active devices (115) of the first semiconductor device tier (111) is comprised in a first front-end-of-line, FEOL, structure (114) of a first die (110) of the 3D IC device (100), wherein the first FEOL structure (114) is arranged at a frontside of the first die (112), and wherein the interconnect structure (126) comprising the plurality of clock signal routing interconnects (221) and the second semiconductor device tier (121) are arranged at a backside of the first die (110), opposite the frontside of the first die (110).

15. The 3D IC device (100) according to claim 14, wherein the second set of active devices (125) of the second semiconductor device tier (121) is comprised in a second FEOL structure of a second die (120) of the 3D IC device (100), or wherein the second set of active devices (124) are backend transistors arranged in the interconnect structure (126) comprising the plurality of clock signal routing interconnects (221).
